# EUROPÄISCHE PATENTANMELDUNG

(11) **EP 1 968 191 A1**
(43) Veröffentlichungstag der Anmeldung: **10.09.2008**
(21) Anmeldenummer: 07004588.5
(22) Anmeldetag: 06.03.2007
(51) Int. Cl.: H03K 17/96

(54) **Bedienungsfeld für eine Warmwasserversorgung**

(71) Anmelder: emz-Hanauer GmbH & Co. KGaA, 92507 Nabburg (DE)
(72) Erfinder: Pindl, Stefan, 92507 Nabburg (DE); Forster, Wolfgang, 92540 Altendorf (DE); Turban, Johann, 92447 Schwarzhofen (DE)
(74) Vertreter: von Hellfeld, Axel

(57) **Zusammenfassung**

Eine Warmwasserversorgung für insbesondere ein Duschpaneel oder dergleichen sieht ein Bedienungsfeld vor zur Erzeugung elektrischer Steuersignale, das hinter einer Glasplatte (38) in einer optisch teildurchlässigen Beschichtung ausgeformt ist.

## Beschreibung

Die Erfindung betrifft ein Bedienungsfeld zur Erzeugung elektrischer Steuersignale für eine Warmwasserversorgung.

Ziel der Erfindung ist es, ein Bedienungsfeld bzw. eine Bedienungseinrichtung zur Erzeugung elektrischer Steuersignale für eine Warmwasserversorgung bereitzustellen, die eine ästhetisch ansprechende Gestaltung bei einfacher und sicherer Bedienbarkeit ermöglichen.

Hierzu lehrt die Erfindung ein Bedienungsfeld zur Erzeugung elektrischer Steuersignale für eine Warmwasserversorgung mit einer im wesentlichen optisch transparenten, ununterbrochenen Deckschicht, insbesondere einer Glasplatte, und einer im wesentlichen optisch teildurchlässigen Beschichtung, insbesondere aus einem Metall, wie Chrom, wobei die Beschichtung zur Erzeugung von auf Berührung ansprechenden elektronischen Tasten durch Trennlinien unterbrochen ist. Solche Tasten werden häufig auch als "kapazitive Tasten" bezeichnet. Es handelt sich um elektrische Schalter, die dann ihren Schaltzustand ändern, wenn sie zum Beispiel von einem Finger berührt werden.

Die optisch teildurchlässige Beschichtung kann zum Beispiel eine optisch teildurchlässige Verspiegelungsschicht sein.

Die Erfindung ermöglicht es, ein Bedienungsfeld mit Tasten dieser Art in eine verspiegelte Glasfront zu integrieren. Die ununterbrochene Deckschicht aus zum Beispiel Glas deckt das gesamte Bedienungsfeld und gegebenenfalls auch darüber hinaus andere Einrichtungen der Warmwasserversorgung, wie zum Beispiel ein Duschpaneel ab, sodass insbesondere die elektrischen und elektronischen Komponenten der Steuerung für die Warmwasserversorgung hinter der ununterbrochenen, beschichteten Glasfront geschützt sind. Dies ermöglicht darüber hinaus eine elegante ästhetische Gestaltung der Warmwasserversorgung, wie insbesondere eines Duschpaneels, mit einer weitgehend glatten Oberfläche, ohne störende Vorsprünge oder Unterbrechungen.

Die Erfindung beruht auf der Erkenntnis, dass die Beschichtung einer Glasscheibe durch Trennlinien durchbrochen werden kann, um so einzelne Tasten in einem Tastenfeld zu erzeugen. Jede einzelne Taste ist also von einem metallfreien Spalt umgeben.

Als Metallschicht für die Beschichtung hat sich insbesondere Chrom bewährt, weil es insbesondere eine sehr wasserbeständige Beschichtung ermöglicht.

Durch die Glasplatte, welche das gesamte Bedienungsfeld abdeckt, erübrigen sich besondere Abdichtungen bezüglich der unter der Glasplatte liegenden elektronischen Komponenten, also der einzelnen Tasten und ihrer elektronischen Verbindungen.

Eine besondere Ausgestaltung der Erfindung sieht eine im wesentlichen lichtundurchlässige Schicht hinter der genannten Beschichtung vor, wobei die lichtundurchlässige Schicht Ausnehmungen aufweist, die einzelnen Symbolen entsprechen, also zum Beispiel Zahlen, Buchstaben etc., mit welchen die einzelnen Tasten belegt sind, um der Bedienungsperson die Funktion der einzelnen Tasten anzuzeigen. Hierzu empfiehlt sich eine Lichtquelle hinter der genannten, die Symbole markierenden undurchlässigen Schicht. Dabei können zur Energieeinsparung nur ganz bestimmte ausgewählte Symbole im sogenannten "Stand-by"-Betrieb geringfügig beleuchtet sein, während alle anderen Tasten in diesem Betriebszustand ohne Beleuchtung verbleiben. Ein Benutzer findet somit auch im Dunkeln oder bei geringfügiger Beleuchtung die schwach beleuchteten Tasten und nach Betätigung der schwach beleuchteten Taste können dann sämtliche Tasten des Bedienfeldes mit der vorgesehenen vollen Leuchtkraft ausgeleuchtet werden.

Die Erfindung beinhaltet auch eine Bedienungseinrichtung zur Erzeugung elektrischer Steuersignale für eine Warmwasserversorgung mit einer elektronischen Steuerung zum Ansteuern zumindest eines Ventils, welches die Strömung von Warmwasser zu einem Warmwasserauslass steuert, wobei ein Temperatursensor im Strömungsweg des Warmwassers angeordnet ist, beispielweise vor oder hinter dem Ventil, und das Ausgangssignals des Temperatursensors bewirkt, dass bei Überschreiten eines vorgegebenen Schwellenwertes der Temperatur des durch das Ventil strömenden Wassers das Ventil geschlossen wird. Diese Bedienungseinrichtung weist gemäß einer bevorzugten Ausgestaltung eine Steuerung mit einer eigenständigen Temperatursperre auf, die das Ausgangssignal des Temperatursensors direkt erhält, also ohne Umweg über eine von einer Bedienungsperson beeinflussbare Steuerung, um bei Überschreiten des Schwellenwertes das Ventil zwangsweise zu schließen. Hierdurch können Verbrühungen durch Heißwasser ausgeschlossen werden. Will ein Benutzer gleichwohl Wassertemperaturen, die über dem vorgegebenen Schwellenwert liegen, erreichen, muss er mittels der Bedienungseinrichtung, also insbesondere mittels des beschriebenen Tastenfeldes, eine besondere Befehlsfolge eingeben, die per Zufall so gut wie ausgeschlossen ist.

Nachfolgend wird ein Ausführungsbeispiel der Erfindung anhand der Zeichnung näher erläutert.

Es zeigt:
- Figur 1: schematisch ein Duschpaneel;
- Figur 2: eine Draufsicht auf ein Bedienungsfeld zur Erzeugung elektrischer Steuersignale für eine Warmwasserversorgung;
- Figur 3: einen Schnitt durch das Bedienungsfeld gemäß Figur 2 entlang der Linie I-II; und
- Figur 4: schematisch eine Warmwasserversorgung mit einem Temperatursensor.

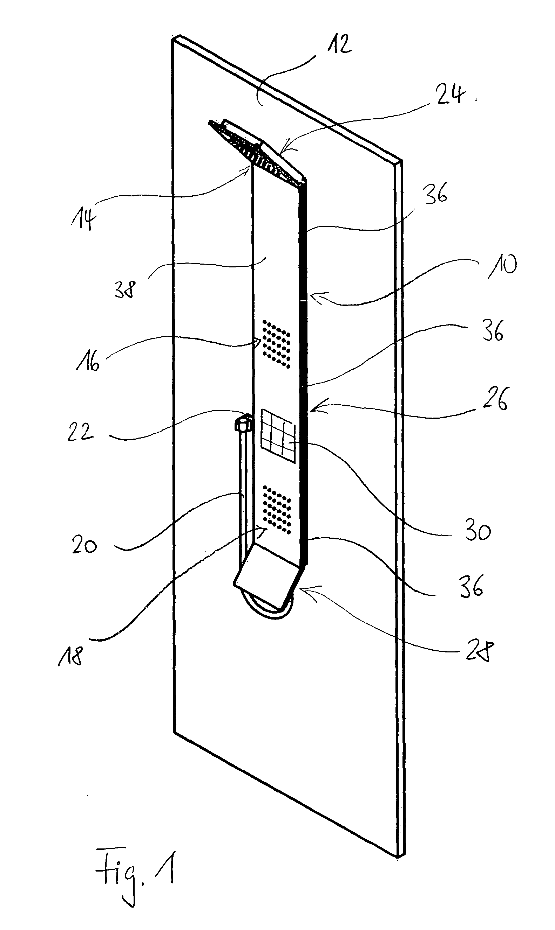

Nachfolgend wird die Erfindung mit Blick auf ein Duschpaneel 10 (Duschplattform) beschrieben, wie es in Figur 1 dargestellt ist. Das Duschpaneel 10 ist an einer Wand befestigt und bildet insgesamt eine kompakte Einheit, die an der Wand (gegebenenfalls aufklappbar) befestigt ist und hinter der alle elektrischen, elektronischen und installationstechnischen Einrichtungen verborgen sind. Der Benutzer sieht nur die über die gesamte Vorderfront verspiegelte Fläche des Duschpaneels mit Öffnungen für Brausen 14, 16 und 18 sowie mit einem Bedienungsfeld 30, welches weiter unten näher beschrieben wird.

Das Duschpaneel 10 ist weiterhin mit einer Aufhängung 22 versehen, um einen Schlauch 20 mit einem beweglichen Brausenkopf einzuhängen. Das Duschpaneel 10 weist einen oberen, in Bezug auf die Wandebene abgewinkelten Bereich 24, einen mittleren, sich parallel zur Wandebene erstreckenden Bereich 26 und einen unteren, wiederum in Bezug auf die Wandebene abgewandelten Bereich 28 auf. Der obere abgewinkelte Bereich 24 dient hier als obere Brause. Dieser Bereich kann zum Beispiel in seinem Winkel einstellbar sein.

Das Duschpaneel 10 weist in einer Höhe, die durch einen Benutzer bequem manuell zugänglich ist, ein Bedienungsfeld 30 auf. Das Bedienungsfeld 30 ermöglicht es dem Benutzer, die Dusche hinsichtlich aller interessierenden Parameter, wie Wasserdruck, Wassertemperatur, ausgewählte Brause etc. einzustellen.

Die einzelnen Wasseranschlüsse, Ventile und auch die Steuerungseinrichtungen hierfür als solche sind dem Fachmann allgemein bekannt und werden hier deshalb nicht näher ausgeführt.

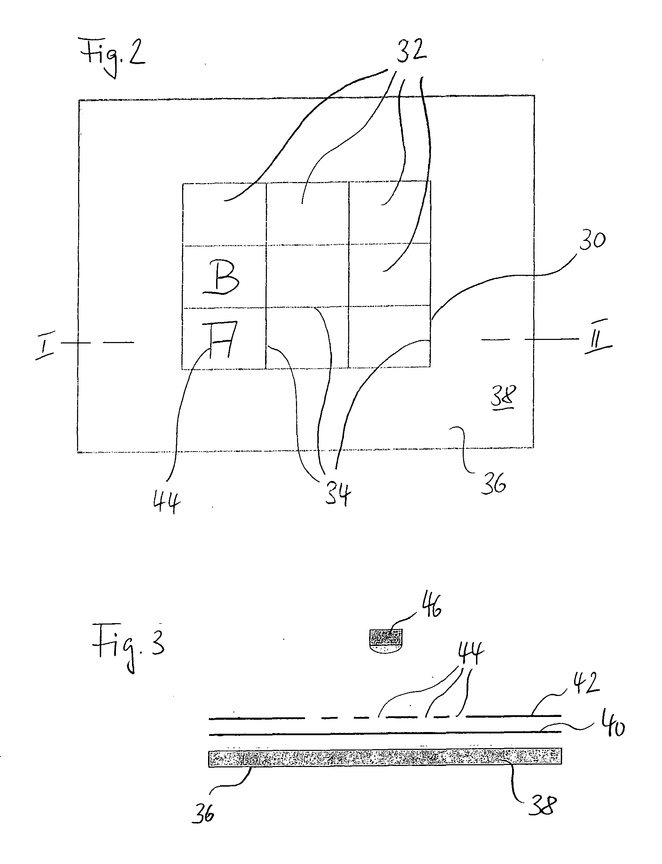

Figur 2 zeigt das Bedienungsfeld 30 mit einzelnen Tasten 32, die durch Trennlinien 34 abgegrenzt sind, wobei die optisch teildurchlässige Beschichtung eine Verspiegelungsschicht sein kann. Die Ausführung kann spiegelnd oder nicht spiegelnd ausgeführt sein. Dabei kann sie in einer beliebigen Farbe, wie zum Beispiel rot oder blau ausgeführt sein.

Das Bedienungsfeld 30 ist, ebenso wie das übrige Duschpaneel 10 vorderseitig im wesentlichen durch eine durchgehende Glasplatte 38 abgedeckt, die eine durchgehende Beschichtung 36 bildet. Hierzu ist auf der Rückseite der Glasplatte 38 (vgl. auch Figur 3) eine optisch teildurchlässige Schicht 40 aufgetragen, welche die Verspiegelung in herkömmlicher Weise erzeugt. Als teildurchlässige Schicht 40 ist beim dargestellten Ausführungsbeispiel eine teildurchlässige Chromschicht vorgesehen. Die Schicht 40 ist insbesondere von hinten (in Figur 3 also von oben) optisch teildurchlässig, sodass beleuchtete Strukturen hinter der Schicht 40 (in Figur 3 oberhalb der Schicht 40) bei Beleuchtung für einen Benutzer sichtbar werden.

Die einzelnen Tasten 32 des Bedienungsfeldes 30 werden erzeugt durch Trennlinien 34, welche die Metallschicht 40 unterbrechen, d.h. die einzelnen Tasten 32 sind elektrisch in Bezug auf die Metallschicht 40 und voneinander isoliert (segmentiert). Die Trennlinien 34 können durch Laserstrahlung erzeugt werden, welche durch die Glasplatte 38 hindurch auf die Schicht 40 fokussiert und entsprechend den Trennlinien geführt wird.

Gemäß Figur 3 ist auf die Schicht 40 eine optisch im wesentlichen undurchlässige Schicht 42 aufgetragen mit Ausnehmungen 44, wobei die Ausnehmungen 44 dazu dienen, Symbole, wie Buchstaben, Zahlen oder andere Bedienungshinweise zu gestalten, vgl. die Buchstaben A, B in Figur 2. Die optisch im wesentlichen undurchlässige Schicht 42 ist zum Beispiel ein keramischer Lack, der besonders wasserbeständig ist.

Hinter der Schicht 42 sind eine oder mehrere Lichtquellen 46 angeordnet. Zum Beispiel kann eine gleichförmige Lichtverteilung über die gesamte Fläche des Bedienfeldes 30 erfolgen oder es können einzelne Lichtquellen jeder einzelnen Taste 32 zugeordnet werden. Bei Beleuchtung von hinten (in Figur 3 also von oben) mit wahlweise ansteuerbaren Lichtquellen 46 lässt sich somit das Tastenfeld mit seinen einzelnen Tasten 32 selektiv ausleuchten und ein Benutzer sieht von vorne nur die ausgeleuchtete Tasten.

Dort wo keine durch Berührung elektronisch betätigbaren Tasten vorgesehen sind, kann auf die beschriebenen Trennlinien 34 verzichtet werden. Es ist also auch möglich, mit der Anordnung gemäß Figur 3 (in diesem Fall ohne Trennlinien) eine ästhetisch ansprechende Anzeige von Symbolen oder dergleichen durchzuführen.

Die durch die in Figur 3 gezeigte Lichtquelle 46 schematisch angedeutete Hintergrundbeleuchtung tritt also durch die Ausnehmungen 44 in der im wesentlichen undurchlässigen Lackschicht hindurch, passiert dann die teildurchlässige Spiegelschicht 40 und die Glasplatte 38.

Die Steuerung der Lichtverhältnisse kann insbesondere so durchgeführt werden, dass im sogenannten "Stand-by"-Betrieb nur eine Taste oder wenige ausgewählte Tasten schwach beleuchtet sind, zum Beispiel mit 10% der vollen Leuchtkraft. Erst bei Betätigung einer der Tasten, werden alle Tasten mit voller Leuchtkraft ausgeleuchtet.

Die Schicht 42 besteht bevorzugt aus einem keramischen Lack, der zum Beispiel in Siebdruck aufgetragen werden kann, um die einzelnen, die Symbole bildenden Ausnehmungen 44 zu erzeugen.

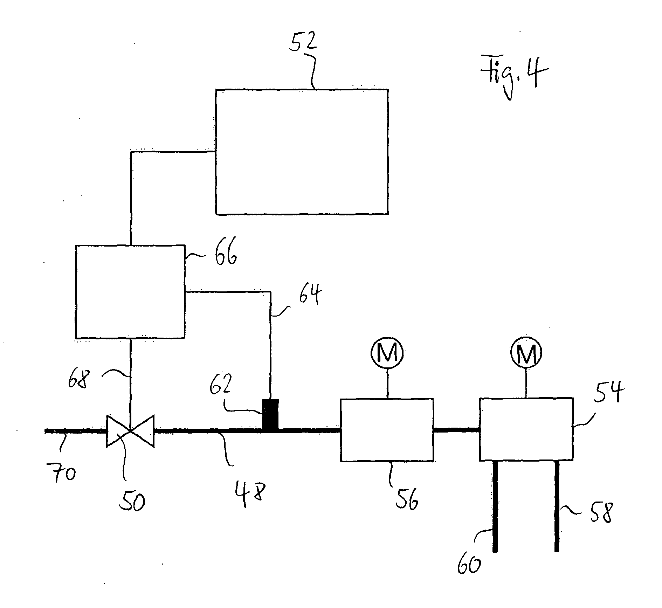

Figur 4 zeigt eine Warmwasserversorgung, wie sie beispielsweise für ein Duschpaneel 10 gemäß Figur 1 einsetzbar ist. Andererseits kann die in Figur 4 gezeigte und nachfolgend beschriebene Warmwasserversorgung auch eigenständig, also ohne ein Duschpaneel 10 oder ein Bedienungsfeld 30 gemäß den Figuren 1 bis 3 eingesetzt werden.

Die Warmwasserversorgung gemäß Figur 4 hat ein Ventil 50, mit dem die Strömung von Warmwasser zu einem Auslass 70 steuerbar ist. Der Auslass 70 kann zum Beispiel eine Brause sein.

Das Ventil 50 wird durch eine programmierte Steuerung 52 angesteuert. Die Steuerung bezieht sich auf die Durchflussrate und/oder den Schließzustand des Ventils 50.

In einer Leitung 48, die über das Ventil 50 zum Auslass 70 führt, ist ein Temperatursensor 62 angeordnet. Über eine Kaltwasserleitung 58 und eine Warmwasserleitung 60 gelangt kaltes bzw. warmes Wasser in einen Thermostaten 54 und von dort über einen Mengenregler 56 in die Leitung 48.

Der Temperatursensor 62 ermittelt die Temperatur des zum Ventil 50 strömenden Wassers und gibt entsprechend der ermittelten Temperatur ein elektrisches Signal über eine elektrische Leitung 64 an eine Temperatursperre 66. Die Temperatursperre 66 steuert über eine Leitung 68 das Ventil 50.

Überschreitet die vom Temperatursensor 62 gemessene Wassertemperatur einen vorgegebenen Schwellenwert von zum Beispiel 39°C, dann schließt die Temperatursperre 66 automatisch das Ventil 50, sodass über den Wasserauslass 70 kein Wasser austreten kann, das heißer als 39°C ist.

Will der Benutzer heißeres Wasser, muss er über zum Beispiel das oben beschriebene Bedienungsfeld 30 eine vorgegebene Tastenfolge betätigen, welche in der Steuerung 52 ausgewertet wird. Ist vom Benutzer die richtige Tastenfolge oder auch die richtige Taste (die zum Beispiel mit "sehr heiß" bezeichnet sein kann) betätigt worden, dann entriegelt die Steuerung 52 die Temperatursperre 66 so, dass das Ventil 50 von der Temperatursperre 66 wieder geöffnet wird. Der Benutzer kann dann über das Bedienfeld 30 die gewünschte, über dem genannten Schwellenwert liegende Temperatur einstellen, wodurch dann die Steuerung veranlasst wird, die Thermostaten und Mengenregler so anzusteuern, dass die gewünschte Temperatur erreicht wird. Dabei ist gemäß einer besonderen Ausgestaltung vorgesehen, die vom Benutzer eingegebene Tastenfolge in einem Speicher zu protokollieren, damit in einem Streitfall die Bedienung der Vorrichtung festgestellt werden kann. Das Protokoll wird in einem Speicher der Steuerung abgelegt und kann durch codierte Tastenfolge abgerufen werden.

## Patentansprüche

1. Bedienungsfeld zur Erzeugung elektrischer Steuersignale für eine Warmwasserversorgung mit
- einer im wesentlichen optisch transparenten, ununterbrochenen Deckschicht (38) und
- einer im wesentlichen optisch teildurchlässigen Beschichtung (40), wobei
- die Beschichtung (40) durch Trennlinien (34) zur Erzeugung von auf Berührung ansprechenden Tasten (32) unterbrochen ist.

2. Bedienungsfeld nach Anspruch 1, **dadurch gekennzeichnet, dass** die Beschichtung (40) Metall aufweist, insbesondere Chrom.

3. Bedienungsfeld nach einem der Ansprüche 1 oder 2, mit einer im wesentlichen undurchlässigen Schicht (42) aus einem Lack, insbesondere einem keramischen Lack, die Ausnehmungen (44) aufweist zur Erzeugung von Symbolen.

4. Bedienungsfeld nach einem der vorhergehenden Ansprüche, **dadurch gekennzeichnet, dass** die transparente Deckschicht (38) eine Glasplatte ist.

5. Bedienungsfeld nach einem der vorhergehenden Ansprüche, **dadurch gekennzeichnet, dass** es in einen großflächigen Spiegel (36) integriert ist, der eine oder mehrere Brausen (14, 16, 18) aufweist.

6. Bedienungsfeld nach einem der Ansprüche 3 bis 5, mit zumindest einer Lichtquelle (46) hinter der undurchlässigen Schicht (42).

7. Bedienungseinrichtung zur Erzeugung elektrischer Steuersignale für eine Warmwasserversorgung (50, 52, 62, 70) mit einer elektronischen Steuerung (52, 66) zum Ansteuern zumindest eines Ventils (50), welches die Strömung von Warmwasser zu einem Wasserauslass (70) steuert,
**gekennzeichnet durch**
einen Temperatursensor (62) im Strömungsweg des Warmwassers, dessen Ausgangssignal an die Steuerung (52, 66) übertragen wird und bei Überschreiten eines vorgegebenen Schwellenwertes der Wassertemperatur die Steuerung veranlasst, das Ventil (50) zu schließen.

8. Bedienungseinrichtung nach Anspruch 7, **dadurch gekennzeichnet, dass** der Schwellenwert bei etwa 39°C liegt.

9. Bedienungseinrichtung nach einem der Ansprüche 7 oder 8, **dadurch gekennzeichnet, dass** die Steuerung (52, 66) eine Temperatursperre (66) aufweist, die das Ausgangssignal des Temperatursensors (62) direkt erhält und die von einer Steuerung (52), welche durch einen Benutzer bedienbar ist, nach einer Ventilschließung zur Öffnung des Ventils betätigbar ist.

10. Bedienungseinrichtung nach Anspruch 9 mit einer Eingabeeinrichtung (30) für die Steuerung (52), wobei eine Öffnung des Ventils (52) im Anschluss an eine Schließung desselben die Betätigung mehrerer Elemente der Eingabeeinrichtung (30) in Folge erfordert.
